# EUROPEAN PATENT APPLICATION

(11) **EP 4 358 116 A1**
(43) Date of publication of application: **24.04.2024**
(21) Application number: 22851989.8
(22) Date of filing: 27.07.2022

(54) **DISPLAY PANEL AND ELECTRONIC DEVICE**

(30) Priority: 03.08.2021 CN 202110884190
(71) Applicant: Huawei Technologies Co., Ltd., Longgang Shenzhen, Guangdong 518129 (CN)
(72) Inventor: TANG, Tao, Shenzhen, Guangdong 518129 (CN); FANG, Jianping, Shenzhen, Guangdong 518129 (CN); LI, Xu, Shenzhen, Guangdong 518129 (CN)
(74) Representative: Körber, Martin Hans
(86) International application number: PCT/CN2022/108154
(87) International publication number: WO 2023/011275

(57) **Abstract**

This application provides a display panel and an electronic device. The display panel includes a substrate, an array layer, a display layer, and a shielding structure. The display layer includes a plurality of light emitting components. Each light emitting component includes a first electrode, a light emitting layer, and a second electrode. A plurality of first electrodes are connected to each other to form a plane first electrode layer. The first electrode layer extends from a display region to a non-display region. The array layer includes a drive circuit located in the non-display region. The shielding structure is located in the non-display region. An orthographic projection of the shielding structure on the substrate partially overlaps an orthographic projection of the first electrode layer on the substrate. A set of the orthographic projection of the shielding structure on the substrate and an orthographic projection, on the substrate, of a part that is of the first electrode layer and that is located in the non-display region covers an orthographic projection of a peripheral circuit on the substrate. In the shielding structure, a structure having a constant potential in the non-display region is equivalently lengthened in a direction close to an edge of the panel. The shielding structure can dissipate a charge on the edge of the display panel, to prevent a static charge from affecting a channel of a transistor in the peripheral circuit.

## Description

This application claims priority to Chinese Patent Application No. 202110884190.8, filed with the China National Intellectual Property Administration on August 3, 2021 and entitled "DISPLAY PANEL AND ELECTRONIC DEVICE", which is incorporated herein by reference in its entirety.

### TECHNICAL FIELD

This application relates to the field of display technologies, and more specifically, to a display panel and an electronic device.

### BACKGROUND

An organic light-emitting diode (OLED) becomes a next-generation mainstream display technology characterized by low power consumption, high contrast, a wide color gamut, a high response speed, self-luminousness, and the like. In addition, self-luminousness of the organic light-emitting diode allows it to be manufactured into a thin display panel, which makes it possible to produce flexible products with foldability and rollability. Under impact of an applied electric field, an existing product is defected by poor display, for example, screen flash, gray spots, or green tints.

### SUMMARY

In view of this, this application provides a display panel and an electronic device, to resolve a problem of poor display under impact of an applied electric field, so as to improve display performance reliability.

According to a first aspect, an embodiment of this application provides a display panel. The display panel includes:
a substrate;
a display layer, located on a side of the substrate, where the display layer includes a plurality of light emitting components, each light emitting component includes a first electrode, a light emitting layer, and a second electrode that are stacked, a plurality of first electrodes are connected to each other to form a first electrode layer, and the first electrode layer extends from a display region to a non-display region;
an array layer, located between the substrate and the display layer, where the array layer includes a peripheral circuit located in the non-display region; and
a shielding structure, where the shielding structure is located in the non-display region, and an orthographic projection of the shielding structure on the substrate partially overlaps an orthographic projection of the first electrode layer on the substrate; and the orthographic projection of the shielding structure on the substrate is a first projection, an orthographic projection, on the substrate, of a part that is of the first electrode layer and that is located in the non-display region is a second projection, and a set of the first projection and the second projection covers an orthographic projection of the peripheral circuit on the substrate.

In an embodiment, the peripheral circuit includes a gate drive circuit. The set of the first projection and the second projection covers an orthographic projection of the gate drive circuit on the substrate. In another embodiment, the peripheral circuit includes a gate drive circuit and a light emitting drive circuit. The set of the first projection and the second projection covers an orthographic projection of the gate drive circuit and an orthographic projection of the light emitting drive circuit on the substrate.

According to the display panel provided in this embodiment of this application, the shielding structure is disposed in the non-display region. The orthographic projection of the shielding structure on the substrate partially overlaps the orthographic projection, on the substrate, of the part that is of the first electrode layer and that is located in the non-display region. When the display panel performs display, a specific voltage is usually applied to the first electrode layer. After the specific voltage is also applied to the shielding structure, a structure having a constant voltage potential in the non-display region is equivalently lengthened in a direction close to an edge of the display panel. In this case, the shielding structure greatly affects a potential on the edge of the display panel. The set of the orthographic projection of the shielding structure on the substrate and the orthographic projection of the part that is of the first electrode layer and that is in the non-display region is set to cover the orthographic projection of the peripheral circuit on the substrate. In this way, after the specific voltage is applied to the shielding structure, the shielding structure can be used to dissipate a charge on the edge of the display panel, to prevent a static charge from affecting a channel of a transistor in the peripheral circuit. In this embodiment of this application, the shielding structure can perform a static electricity shielding function, to reduce a risk of a circuit failure caused by a characteristic offset of the transistor in the peripheral circuit due to static electricity, so as to reduce a risk of poor display under impact of an applied electric field.

In some implementations, the peripheral circuit includes a plurality of transistors. The transistor includes a channel. The shielding structure is located on a side that is of the channel and that is away from the substrate. In this embodiment of this application, the shielding structure is disposed on the side that is of the channel and that is away from the substrate. When a static charge generated by the display panel is conducted from a display surface to a back film, the static charge is first dissipated by the shielding structure after being transferred to the shielding structure. This can block conduction of static electricity to the back film, thereby preventing the static electricity from affecting a characteristic of the transistor in the peripheral circuit.

In some other implementations, the shielding structure and the second electrode are located at a same layer.

In some other implementations, the shielding structure includes a first shielding layer and a second shielding layer. An orthographic projection, on the substrate, of an end that is of the first shielding layer and that is close to the display region partially overlaps the orthographic projection of the first electrode layer on the substrate. An orthographic projection, on the substrate, of an end that is of the first shielding layer and that is away from the display region overlaps an orthographic projection of the second shielding layer on the substrate. The first shielding layer is connected to the second shielding layer through a via. In this implementation, the two shielding layers jointly form the shielding structure. The second shielding layer is farther away from the display region compared with the first shielding layer. When the shielding layers are produced by using existing film layers in the display panel, positions of the film layers at which the first shielding layer and the second shielding layer are respectively located can be designed, to avoid an existing circuit in the non-display region.

In some implementations, the first shielding layer and the second electrode are located at a same layer. The second shielding layer is located at a metal layer that is at the array layer and that is closest to the display layer. In this implementation, both the first shielding layer and the second shielding layer are produced by reusing the original film layers in the display panel, and no new technological production process is added. The first shielding layer is first disposed to overlap an edge of the first electrode layer. After extending in a direction that is away from the display region, the first shielding layer overlaps and is electrically connected to the second shielding layer located at the array layer. The first shielding layer and the second electrode are located at the same layer. In this way, the first shielding layer is disposed, without affecting normal circuit wiring at the array layer.

In some implementations, the shielding structure is located on a side that is of the channel and that is close to the substrate. In an application process of the display panel, a charge generated by the back film through induction can be dissipated by the shielding structure. This can block conduction of static electricity to a film layer at which the channel is located, thereby preventing the static electricity from affecting the characteristic of the transistor in the peripheral circuit.

In some implementations, the display panel further includes a light shielding layer located in the display region. The shielding structure and the light shielding layer are located at a same layer. The shielding structure and the light shielding layer can be produced in a same technological production process. The shielding structure is produced without adding a new technological production process, and a technology is simple.

The display panel further includes a voltage terminal located in the non-display region. The shielding structure is electrically connected to the voltage terminal. The voltage terminal is reused as a ground terminal or reused as a voltage terminal that provides a voltage to the first electrode layer.

According to a second aspect, an embodiment of this application further provides an electronic device, including the display panel provided in any embodiment of this application.

The display panel and the electronic device that are provided in this application have the following advantageous effects: The shielding structure is disposed in the non-display region of the display panel. The orthographic projection of the shielding structure on the substrate partially overlaps the orthographic projection, on the substrate, of the part that is of the first electrode layer and that is in the non-display region. When the display panel performs display, the specific voltage is usually applied to the first electrode layer. After the specific voltage is also applied to the shielding structure, the structure having the constant voltage potential in the non-display region is equivalently lengthened in a direction close to the edge of the display panel. In this case, the shielding structure greatly affects the potential on the edge of the display panel. The set of the orthographic projection of the shielding structure on the substrate and the orthographic projection of the part that is of the first electrode layer and that is in the non-display region covers an orthographic projection of a drive circuit on the substrate. In this way, after the specific voltage is applied to the shielding structure, the shielding structure can be used to dissipate the charge on the edge of the display panel, to prevent the static charge from affecting the channel of the transistor in a peripheral circuit. In embodiments of this application, the shielding structure can perform the static electricity shielding function, to reduce the risk of the circuit failure caused by the characteristic offset of the transistor in the peripheral circuit due to the static electricity, so as to reduce the risk of poor display under impact of the applied electric field.

### BRIEF DESCRIPTION OF DRAWINGS

FIG. 1 is a schematic diagram of a display panel according to an embodiment of this application;
FIG. 2 is a cross sectional schematic view at a cutting line A-A' in FIG. 1;
FIG. 3 is a simplified local schematic diagram of a display panel according to an embodiment of this application;
FIG. 4 is another simplified local schematic diagram of a display panel according to an embodiment of this application;
FIG. 5 is another cross sectional schematic view at a cutting line A-A' in FIG. 1;
FIG. 6 is another cross sectional schematic view at a cutting line A-A' in FIG. 1;
FIG. 7 is another cross sectional schematic view at a cutting line A-A' in FIG. 1;
FIG. 8 is a schematic top view of a display panel according to an embodiment of this application;
FIG. 9 is another schematic top view of a display panel according to an embodiment of this application;
FIG. 10 is a local schematic top view of a display panel according to an embodiment of this application;
FIG. 11 is another cross sectional schematic view at a cutting line A-A' in FIG. 1; and
FIG. 12 is a schematic diagram of an electronic device according to an embodiment of this application;

### DESCRIPTION OF EMBODIMENTS

In the conventional technology, an anti-fingerprint coating is disposed on a surface of a display panel. The anti-fingerprint coating includes high-concentration fluorine elements. As a result, when an electronic product is used, a negative charge is accumulated due to friction. As a result, a back film of the display panel generates a charge through induction. In addition, because the film layer at which a channel of a transistor is located is close to the back film, a charge in the back film causes a characteristic offset of the transistor in a peripheral circuit. This affects driving performance of the peripheral circuit for a light-emitting diode, resulting in a display failure. On the basis of this, embodiments of this application provide a display panel. A shielding structure is disposed in a non-display region. The shielding structure is used to dissipate a static charge, to resolve a problem of a failure of a peripheral circuit occurring because static electricity cannot be dissipated in a timely manner.

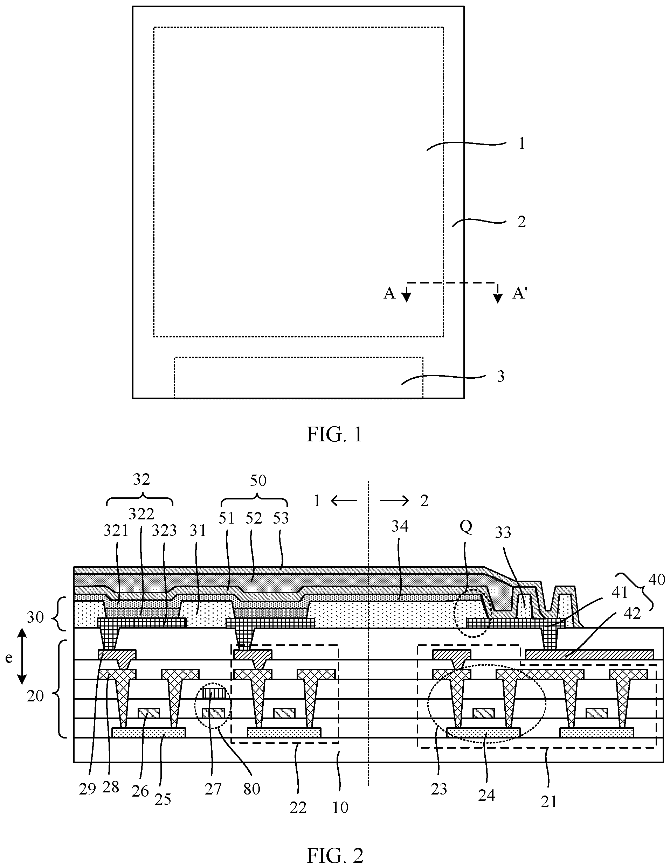

FIG. 1 is a schematic diagram of a display panel according to an embodiment of this application. FIG. 2 is a cross sectional schematic view at a cutting line A-A' in FIG. 1.

As shown in FIG. 1, the display panel includes a display region 1 and a non-display region 2 surrounding the display region 1. A binding region 3 is further disposed in the non-display region 2. A plurality of connection terminals (not shown in FIG. 1) are disposed in the binding region 3. In an embodiment, a drive chip is disposed in the non-display region 2 of the display panel. The connection terminals are connected to pins on the drive chip in a one-to-one correspondence. In another embodiment, a flexible circuit board is fastened to the non-display region 2 of the display panel. In this case, the connection terminals are connected to pins on the flexible circuit board in a one-to-one correspondence.

As shown in FIG. 2, the display panel includes a substrate 10, an array layer 20, and a display layer 30. Optionally, the substrate 10 is a flexible substrate, for example, a PI (polyimide) substrate.

The display layer 30 is located on a side of the substrate 10. The display layer 30 may include a pixel definition layer 31 and a plurality of light emitting components 32. Each light emitting component 32 includes a first electrode 321, a light emitting layer 322, and a second electrode 323 that are stacked. The first electrode 321 is located on a side that is of the second electrode 323 and that is away from the substrate 10. In an embodiment, the light emitting component 32 is an organic light-emitting diode. In another embodiment, the light emitting component 32 is an inorganic light-emitting diode. A plurality of first electrodes 321 are connected to each other to form a first electrode layer 34. The first electrode layer 34 extends from the display region 1 to the non-display region 2. In other words, the first electrode layer 34 is an entire-layer structure that covers the display region 1 and extends to the non-display region 2. The first electrode layer 34 is equivalent to a common electrode layer. In an embodiment, the first electrode 321 is a cathode, and the second electrode 323 is an anode. In this case, the first electrode layer 34 is a cathode layer.

The array layer 20 is located between the substrate 10 and the display layer 30. The array layer 20 includes a peripheral circuit 21 located in the non-display region 2, and further includes a pixel circuit 22 located in the display region 1. The pixel circuit 22 is electrically connected to the light emitting component 32. An output end of the pixel circuit 22 is electrically connected to the second electrode 323 of the light emitting component 32. The pixel circuit 22 provides a voltage signal to the second electrode 323, and applies a common voltage signal to the first electrode 321. In this way, the light emitting component 32 emits light under control of the first electrode 321 and the second electrode 323. The pixel circuit 22 in FIG. 2 is merely a simplified example.

The peripheral circuit 21 includes a plurality of transistors 23. The transistor 23 includes a channel 24. The transistor 23 includes a gate, a source, and a drain. A conductive semiconductor between the source and the drain is the channel 24. In some embodiments, the array layer 20 may further include a semiconductor layer 25 located on the substrate 10. The channel 24 is located at the semiconductor layer 25. During production of the display panel, after the patterned semiconductor layer 25 is produced, ions are injected, by using a channel doping technology, into a region in which a channel is pre-disposed, to finally form the channel 24.

A working cycle of the pixel circuit 22 includes at least a data write phase and a light emitting phase. In the data write phase, a data signal provided on a data cable is written to a gate of a drive transistor in the pixel circuit 22. In the light emitting phase, the drive transistor generates a drive current under control of a gate voltage of the drive transistor.

In some other embodiments, the peripheral circuit 21 may further include a gate drive circuit. The gate drive circuit includes a plurality of cascaded first shift registers. The display panel further includes a plurality of scanning lines. The scanning line is electrically connected to an output end of the first shift register. The pixel circuit 22 includes a scan control end. The scan control end is electrically connected to the scanning line. The plurality of cascaded first shift registers sequentially provide scanning signals to the plurality of scanning lines, and then input the scanning signals to the scan control end through the scanning lines, to control the pixel circuit 22 to work in the data write phase.

In another embodiment, the peripheral circuit 21 further includes a gate drive circuit and a light emitting drive circuit. The light emitting drive circuit includes a plurality of cascaded second shift registers. The display panel further includes a plurality of light emitting control lines. The light emitting control line is electrically connected to an output end of the second shift register. The pixel circuit 22 further includes a light emitting control end. The light emitting control end is electrically connected to the light emitting control line. The plurality of cascaded second shift registers sequentially provide light emitting control signals to the plurality of light emitting control lines, and then provide the light emitting control signals to the light emitting control end through the light emitting control lines, to control the pixel circuit 22 to work in the light emitting phase. Under cooperative control of the gate drive circuit and the light emitting drive circuit, the output end of the pixel circuit 22 provides a voltage signal to the second electrode 323.

In some embodiments, as shown in FIG. 2, the display panel may further include an encapsulation layer 50. The encapsulation layer 50 is configured to perform encapsulation protection on the light emitting component 32. In some embodiments, the encapsulation layer 50 may include a first inorganic layer 51, an organic layer 52, and a second inorganic layer 53 that are stacked. FIG. 2 further shows a barrier wall 33 located in the non-display region 2. The barrier wall 33 is configured to limit an edge of the encapsulation layer 50, and can prevent a crack on the edge of the encapsulation layer 50 from extending to the display region. In some embodiments, structures such as a crack detection line and a crack barrier wall may be further disposed in the non-display region 2. The crack detection line is configured to detect a crack status in the non-display region before delivery of the display panel. The crack barrier wall is configured to block a crack in the non-display region 2, to prevent the crack from extending to the display region 1.

In some other embodiments, as shown in FIG. 2, the display panel may further include a shielding structure 40. The shielding structure 40 is located in the non-display region 2. It can be learned from a position of a region Q circled in FIG. 2 that, in a direction e perpendicular to a plane on which the substrate 10 is located, the shielding structure 40 at least partially overlaps an edge of the first electrode layer 34. FIG. 2 shows the direction e perpendicular to the substrate 10. It may be understood that the direction e perpendicular to the plane on which the substrate 10 is located is the same as a projection direction in orthographic projection is performed toward the substrate 10. The shielding structure 40 overlaps the edge of the first electrode layer 34. In other words, an orthographic projection of the shielding structure 40 on the substrate 10 partially overlaps an orthographic projection of the first electrode layer 34 on the substrate 10.

In FIG. 2, a position of the peripheral circuit 21 is simplified. The orthographic projection of the shielding structure 40 on the substrate 10 is a first projection. An orthographic projection, on the substrate 10, of a part that is of the first electrode layer 34 and that is located in the non-display region 2 is a second projection. It can be learned that, a set of the first projection and the second projection covers an orthographic projection of the peripheral circuit 2 1 on the substrate 10.

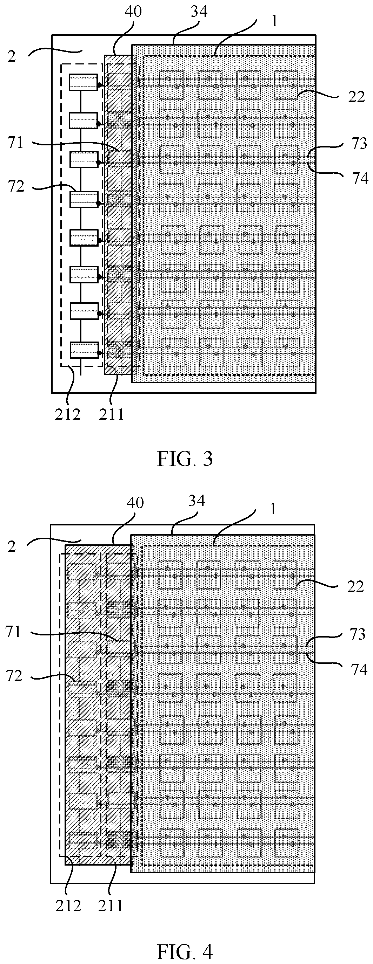

In an embodiment, FIG. 3 is a simplified local schematic diagram of the display panel according to an embodiment of this application. FIG. 3 shows the pixel circuit 22 located in the display region 1, and a gate drive circuit 211 and a light emitting drive circuit 212 that are located in the non-display region 2. The gate drive circuit 211 includes a plurality of cascaded first shift registers 71. The light emitting drive circuit 212 includes a plurality of cascaded second shift registers 72. The pixel circuit 22 is connected to the first shift register 71 through a scanning line 73. The pixel circuit 22 is further connected to the second shift register 72 through a light emitting control line 74. The first electrode layer 34 extends from the display region 1 to the non-display region 2. The set of the orthographic projection of the shielding structure 40 on the substrate 10 and the orthographic projection, on the substrate, of the part that is of the first electrode layer 34 and that is located in the non-display region 2 covers an orthographic projection of the gate drive circuit 211 on the substrate 10.

In another embodiment, FIG. 4 is another simplified local schematic diagram of the display panel according to an embodiment of this application. As shown in FIG. 4, a set of the orthographic projection of a shielding structure 40 on the substrate 10 and the orthographic projection, on the substrate, of the part that is of the first electrode layer 34 and that is located in the non-display region 2 covers an orthographic projection of the gate drive circuit 211 on the substrate 10 and an orthographic projection of the light emitting drive circuit 212 on the substrate 10.

According to the display panel provided in the foregoing embodiments of this application, the shielding structure 40 is disposed in the non-display region. The orthographic projection of the shielding structure 40 on the substrate 10 overlaps the orthographic projection, on the substrate 10, of the part that is of the first electrode layer 34 and that is in the non-display region 2. When the display panel performs display, a specific voltage is usually applied to the first electrode layer 34. After the specific voltage is also applied to the shielding structure 40 (the shielding structure 40 may be grounded, or the shielding structure 40 and the first electrode layer 34 are set to connect to a same voltage signal). A structure having a constant voltage potential in the non-display region 2 is equivalently lengthened in a direction close to the edge of the display panel. In this case, the shielding structure 40 greatly affects a potential on the edge of the display panel. The set of the orthographic projection of the shielding structure 40 on the substrate 10 and the orthographic projection of the part that is of the first electrode layer 34 and that is in the non-display region 2 is set to cover the orthographic projection of the peripheral circuit 21 on the substrate 10. In this way, after the specific voltage is applied to the shielding structure, the shielding structure 40 can be used to dissipate a charge on the edge of the display panel, to prevent a static charge from affecting the channel of the transistor in the peripheral circuit 21. In an embodiment of this application, the shielding structure 40 can perform a static electricity shielding function, to reduce a risk of a circuit failure caused by a characteristic offset of the transistor in the peripheral circuit due to static electricity, so as to reduce a risk of poor display under impact of an applied electric field.

In some other embodiments of this application, the shielding structure 40 may be located between the substrate 10 and the first electrode layer 34. In this case, the shielding structure 40 is produced before a technology of the encapsulation layer 50 of the display panel. The shielding structure 40 can be produced by reusing a technological production process of the array layer 20 or the display layer 30. In addition, a voltage terminal that provides a voltage to the shielding structure 40 is usually disposed at the array layer 20. The shielding structure 40 is disposed between the substrate 10 and the first electrode layer 34. In this way, a connection between the shielding structure 40 and the voltage terminal that provides the voltage to the shielding structure 40 is implemented more easily.

In some other implementations, film layers such as a polarizing layer, a protective layer, an anti-fingerprint layer, and an anti-glare layer may be further disposed on the encapsulation layer 50.

As shown in FIG. 2, the shielding structure 40 is located on a side that is of the channel 24 and that is away from the substrate 10. In an application process of the display panel, a negative charge is generated on a side of a display surface of the display panel due to friction. The display surface is also an out-light surface. The negative charge generated on the side of the display surface causes a back film of the display panel to generate a charge through induction. Compared with that in another circuit structure, the channel of the transistor is closer to the substrate 10 (namely, a side of the back of the display panel). In an embodiment of this application, the shielding structure 40 is disposed on the side that is of the channel 24 and that is away from the substrate 10. When a static charge generated by the display panel is conducted from the display surface to a back film, the static charge is first dissipated by the shielding structure 40 after being transferred to the shielding structure 40. This can block conduction of static electricity to the back film, thereby preventing the static electricity from affecting a characteristic of the transistor in the peripheral circuit.

As shown in FIG. 2, the shielding structure 40 includes a first shielding layer 41 and a second shielding layer 42. In the direction e perpendicular to the plane on which the substrate 10 is located, an end that is of the first shielding layer 41 and that is close to the display region 1 overlaps the edge of the first electrode layer 34, and an end that is of the first shielding layer 41 and that is away from the display region 1 overlaps the second shielding layer 42. In other words, an orthographic projection, on the substrate 10, of the end that is of the first shielding layer 41 and that is close to the display region 1 overlaps the orthographic projection of the first electrode layer 34 on the substrate 10. An orthographic projection, on the substrate 10, of the end that is of the first shielding layer 41 and that is away from the display region 1 overlaps an orthographic projection of the second shielding layer 42 on the substrate 10. In addition, the first shielding layer 41 is connected to the second shielding layer 42 through a via. After the specific voltage is applied to the shielding structure 40, the first shielding layer 41 and the second shielding layer 42 have a same potential. In this implementation, the two shielding layers jointly form the shielding structure 40. The second shielding layer 42 is farther away from the display region 1 compared with the first shielding layer 41. When the shielding layers are produced by using existing film layers in the display panel, positions of the film layers at which the first shielding layer 41 and the second shielding layer 42 are respectively located can be designed, to avoid an existing peripheral circuit in the non-display region.

In some implementations, the first shielding layer 41 and the second electrode 323 are located at a same layer. The second shielding layer 42 is located at a metal layer that is at the array layer 20 and that is closest to the display layer 30. In this implementation, both the first shielding layer 41 and the second shielding layer 42 are produced by reusing the original film layers in the display panel, and no new technological production process is added. Structures such as a common voltage bus and the peripheral circuit 21 are disposed in the non-display region 2. A metal layer at the array layer 20 is used to produce the pixel circuit in the display region 1, and is further used to produce the peripheral circuit in the non-display region 2. The common voltage bus is electrically connected to the first electrode layer 34, and is configured to provide a voltage signal to the first electrode layer 34. When the original film layer in the display panel is reused to produce the shielding structure 40, to ensure that the shielding structure 40 overlaps the edge of the first electrode layer 34 in the direction e perpendicular to the plane on which the substrate 10 is located, if the metal layer at the array layer 20 is independently used to produce the shielding structure 40, normal wiring in the non-display region 2 may be affected. In embodiments of this application, the first shielding layer 41 is first disposed to overlap the edge of the first electrode layer 34. After extending in a direction that is away from the display region 1, the first shielding layer 41 overlaps and is electrically connected to the second shielding layer 42 located at the array layer 20. The first shielding layer 41 is disposed, without affecting normal circuit wiring at the array layer 20.

In some embodiments, as shown in FIG. 2, the display panel includes a semiconductor layer 25, a first metal layer 26, a second metal layer 27, a third metal layer 28, and a fourth metal layer 29 that are located on the substrate 10 and that are sequentially away from the substrate 10. The fourth metal layer 29 is a metal layer closest to the display layer 30 in this embodiment. Optionally, the second shielding layer 42 is located at the fourth metal layer 29.

In some other embodiments, the pixel circuit 22 may further include a storage capacitor. As shown in FIG. 2, one plate of a storage capacitor 80 is located at the first metal layer 26, and the other plate is located at the second metal layer 27. The display panel further includes a scanning line, a data cable, a light emitting control line, a power cable, and the like. The scanning line is electrically connected to the gate drive circuit. The light emitting control line is electrically connected to the light emitting drive circuit. The scanning line, the data cable, the light emitting control line, and the power cable are separately disposed in the four metal layers. In an embodiment, the scanning line is located at the first metal layer 26. The light emitting control line is located at the second metal layer 27. The data cable and the power cable are located at the third metal layer 28. An auxiliary power cable is further disposed at the fourth metal layer 29. The auxiliary power cable is connected in parallel to the power cable, to reduce a voltage drop on the power cable.

In some embodiments, the first metal layer 26 and the second metal layer 27 are produced by using a same material. The production material of the first metal layer 26 and the second metal layer 27 includes molybdenum. In some embodiments, a production material of the third metal layer 28 includes titanium and aluminum. In an embodiment, the third metal layer 28 is a titanium/aluminum/titanium three-layer structure. In some other embodiments, the fourth metal layer 29 and the third metal layer 28 are produced by using a same material.

In addition, in an embodiment of this application, an orthographic projection of the encapsulation layer 50 on the substrate 10 covers an orthographic projection of the first shielding layer 41 on the substrate 10. The first shielding layer 41 and the second electrode 323 in the light emitting component 32 are located at a same layer. This can ensure that the first shielding layer 41 is covered by the encapsulation layer 50, thereby avoiding a disadvantage due to exposure of the first shielding layer 41.

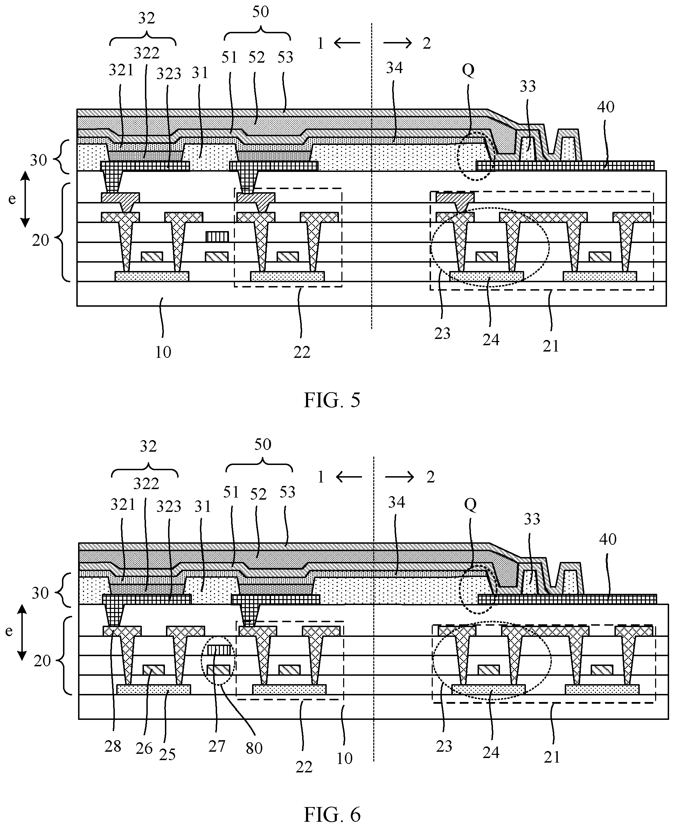

In another embodiment, FIG. 5 is another cross sectional schematic view at the cutting line A-A' in FIG. 1. As shown in FIG. 5, the shielding structure 40 and the second electrode 323 are located at the same layer.

In another embodiment, FIG. 6 is another cross sectional schematic view at the cutting line A-A' in FIG. 1. As shown in FIG. 6, the display panel includes the semiconductor layer 25, the first metal layer 26, the second metal layer 27, and the third metal layer 28 that are located on the substrate 10 and that are sequentially away from the substrate 10. The shielding structure 40 and the second electrode 323 in the light emitting component 32 are located at the same layer. In this implementation, the channel 24 of the transistor is located at the semiconductor layer 25. One plate of the storage capacitor 80 is located at the first metal layer 26. The other plate is located at the second metal layer 27. The scanning line is located at the first metal layer 26. The light emitting control line is located at the second metal layer 27. The data cable and the power cable are located at the third metal layer 28.

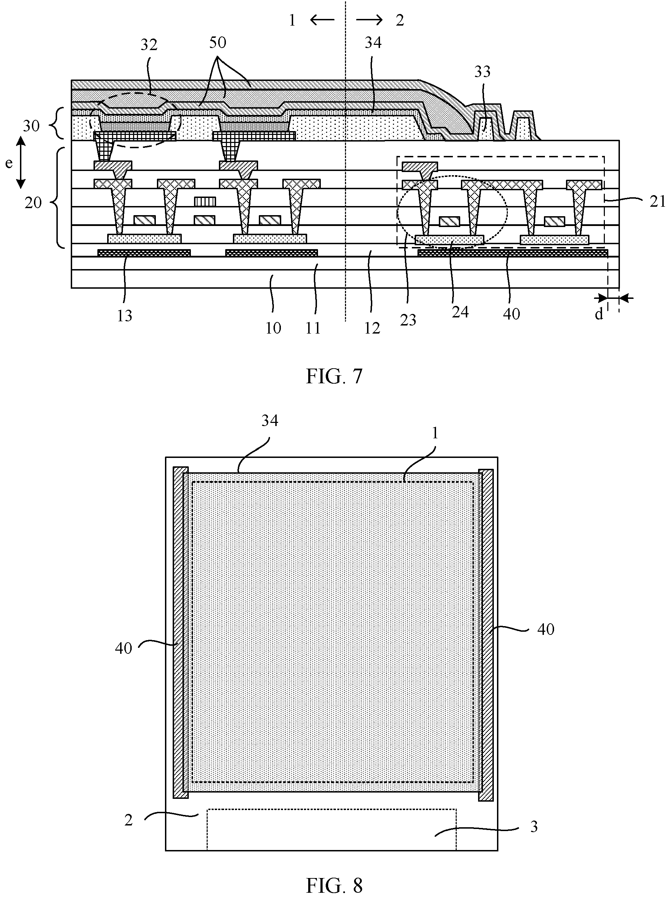

In some implementations, FIG. 7 is another cross sectional schematic view at the cutting line A-A' in FIG. 1. As shown in FIG. 7, in the direction e perpendicular to the plane on which the substrate 10 is located, the shielding structure 40 overlaps the edge of the first electrode layer 34. The shielding structure 40 is located on a side that is of the channel 24 and that is close to the substrate 10. In an application process of the display panel, the charge generated by the back film through induction can be dissipated by the shielding structure 40. This can block conduction of the static electricity to the film layer at which the channel is located, thereby preventing the static electricity from affecting the characteristic of the transistor in the peripheral circuit.

As shown in FIG. 7, a blocking layer 11 and a buffer layer 12 are further disposed between the substrate 10 and the array layer 20. The blocking layer 11 is located on a side that is of the buffer layer 12 and that is close to the substrate 10. In an embodiment, the shielding structure 40 is located between the blocking layer 11 and the buffer layer 12. In another embodiment, the shielding structure 40 is located between the substrate 10 and the blocking layer 11. In another embodiment, the display panel includes two blocking layers. The shielding structure 40 is located between the two blocking layers.

As shown in FIG. 7, the display panel further includes a light shielding layer 13 located in the display region 1. An orthographic projection of the light shielding layer 13 on the substrate 10 covers an orthographic projection of the channel of the transistor in the display region 1 on the substrate 10.

In an embodiment, the shielding structure 40 and the light shielding layer 13 are located at a same layer. In other words, the shielding structure 40 and the light shielding layer 13 can be produced in a same technological production process. The shielding structure is produced without adding a new technological production process, and a technology is simple.

In addition, in an embodiment in FIG. 7, an example in which the array layer 20 includes four metal layers is used for description (refer to the related descriptions in FIG. 2). In another embodiment, the array layer 20 includes the three metal layers as shown in FIG. 6. The shielding structure 40 is located on the side that is of the channel 24 and that is close to the substrate 10. This is not shown in the accompanying drawing herein again.

In some embodiments, as shown in FIG. 7, a distance between an edge of a side that is of the shielding structure 40 and that is away from the display region 1 and an edge of the display panel is d. Herein, d # 0, and d ranges from several micrometers to dozens of micrometers. The shielding structure 40 is not exposed on the edge of the side of the display panel, to avoid a disadvantage caused by exposure of a conductive structure on the edge of the side.

In some embodiments, the edge of the side that is of the shielding structure 40 and that is far away from the display region 1 is basically aligned with the edge of the display panel. This is not shown in the accompanying drawing herein again.

In an embodiment, FIG. 8 is a schematic top view of the display panel according to an embodiment of this application. As shown in FIG. 8, the first electrode layer 34 extends from the display region 1 to the non-display region 2. The shielding structure 40 is disposed on two sides of the display region 1. The shielding structure 40 overlaps at least a part of an edge that is of the first electrode layer 34 and that is in the non-display region 2.

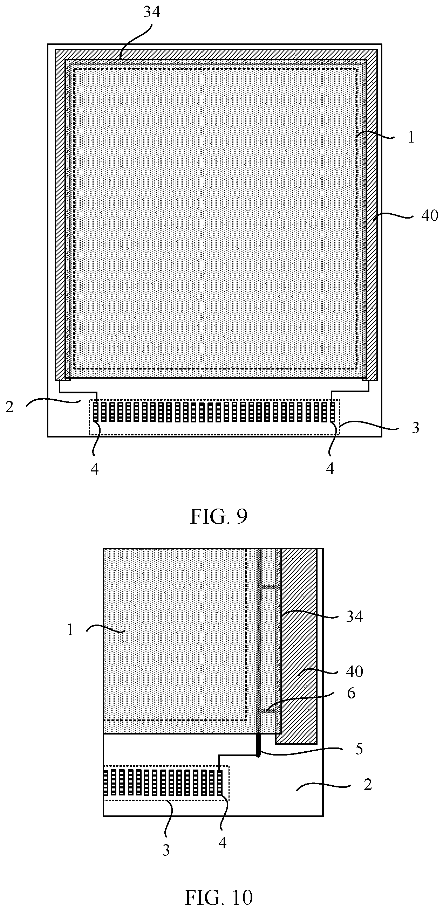

In another embodiment, FIG. 9 is another schematic top view of the display panel according to an embodiment of this application. As shown in FIG. 9, the first electrode layer 34 extends from the display region 1 to the non-display region 2. The shielding structure 40 is disposed half encircling the display region 1. The shielding structure 40 overlaps at least the part of the edge of the first electrode layer 34 in the non-display region 2.

FIG. 9 further shows a plurality of connection terminals located in the binding region 3. The connection terminal includes at least one voltage terminal 4. The shielding structure 40 is electrically connected to the voltage terminal 4. The shielding structure 40 shown in FIG. 9 is connected to the voltage terminal 4 through a connection line on the display panel. During application, a drive chip or a flexible circuit board is disposed on the display panel. A specific voltage signal is provided to the voltage terminal 4 by using the drive chip or the flexible circuit board, to apply the specific voltage to the shielding structure 40. A voltage value of the voltage signal connected to the shielding structure 40 may be set based on a specific requirement.

In some implementations, the voltage terminal 4 is reused as a ground terminal or reused as a voltage terminal that provides a voltage to the first electrode layer 34.

In an embodiment, FIG. 10 is another local schematic top view of the display panel according to an embodiment of this application. As shown in FIG. 10, a common voltage bus 5 is further disposed in the non-display region 2. The common voltage bus 5 is electrically connected to the first electrode layer 34, and is configured to provide the voltage signal to the first electrode layer 34. The common voltage bus 5 extends to the binding region 3 and is electrically connected to the voltage terminal 4. The shielding structure 40 is connected to the common voltage bus 5 through a connection line 6, so that the shielding structure 40 is connected to the voltage terminal 4. In this implementation, the shielding structure 40 and the first electrode layer 34 have a same potential.

In this application, a position of a film layer at which the common voltage bus 5 is located and a related position between the common voltage bus 5 and the peripheral circuit 21 are not limited. Circuit wiring in the non-display region 2 is also complex. During design, the connection line 6 configured to connect the shielding structure 40 to the common voltage bus 5 may need to avoid existing circuit wiring. Specifically, the connection line 6 may be designed based on the position of the film layer at which the common voltage bus 5 is located, a position of a film layer at which the shielding structure 40 is located, and a related surrounding circuit wiring status.

Optionally, in an embodiment of this application, a production material of the shielding structure includes a metal material, a metal oxide, or a metal alloy. The metal material includes any one or more of metals such as molybdenum, titanium, aluminum, and cadmium. The metal oxide is, for example, an indium tin oxide.

In some implementations, a production material of the shielding structure may alternatively be an organic polymer material having specific conductivity.

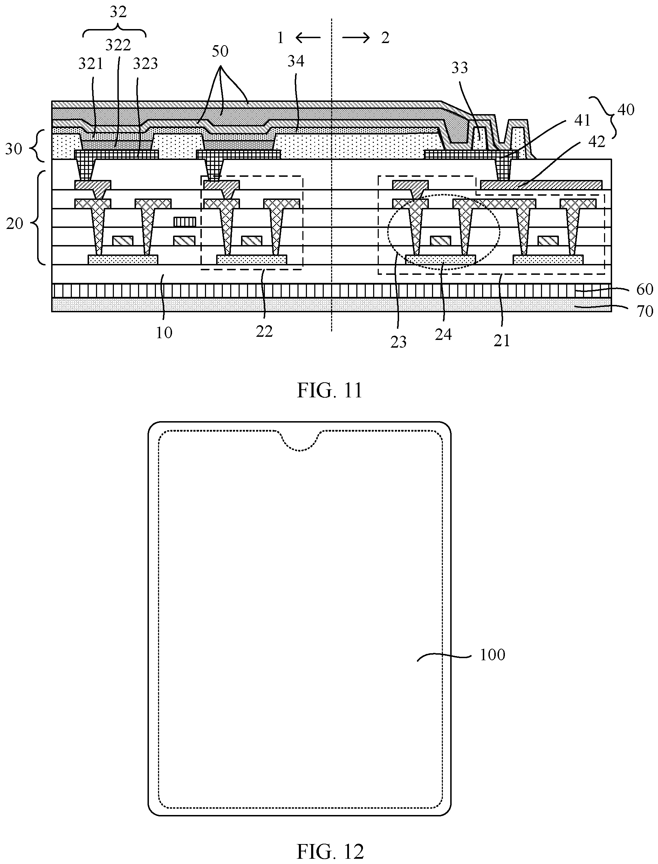

In another embodiment, FIG. 11 is another cross sectional schematic view at the cutting line A-A' in FIG. 1. As shown in FIG. 11, the display panel further includes a support layer 60 and a heat dissipation layer 70 that are located on a side that is of the substrate 10 and that is away from the array layer 20. The support layer 60 is configured to perform support protection on an entire structural layer at the back of the display panel, to ensure anti-impact performance of the side of the back of the display panel. The heat dissipation layer 70 can dissipate heat, to avoid an abnormal operation of a component due to an excessively high temperature when the display panel works. In some implementations, the heat dissipation layer 70 includes a copper foil layer and foam.

An embodiment of this application further provides an electronic device. FIG. 12 is a schematic diagram of an electronic device according to embodiments of this application. As shown in FIG. 12, the electronic device includes a display panel 100 provided in any embodiment of this application. A structure of the display panel 100 is described in the foregoing embodiments of the display panel. Details are not described herein again. The electronic device provided in embodiments of this application may be an electronic device, for example, a mobile phone, a tablet computer, a notebook computer, a television, or a smart wearable device.

## Claims

1. A display panel, wherein the display panel comprises:
a substrate;
a display layer, located on a side of the substrate, wherein the display layer comprises a plurality of light emitting components, each light emitting component comprises a first electrode, a light emitting layer, and a second electrode that are stacked, a plurality of first electrodes are connected to each other to form a first electrode layer, and the first electrode layer extends from a display region to a non-display region;
an array layer, located between the substrate and the display layer, wherein the array layer comprises a peripheral circuit located in the non-display region; and
a shielding structure, wherein the shielding structure is located in the non-display region, and an orthographic projection of the shielding structure on the substrate partially overlaps an orthographic projection of the first electrode layer on the substrate; and the orthographic projection of the shielding structure on the substrate is a first projection, an orthographic projection, on the substrate, of a part that is of the first electrode layer and that is located in the non-display region is a second projection, and a set of the first projection and the second projection covers an orthographic projection of the peripheral circuit on the substrate.

2. The display panel according to claim 1, wherein
the peripheral circuit comprises a plurality of transistors, and the transistor comprises a channel; and
the shielding structure is located on a side that is of the channel and that is away from the substrate.

3. The display panel according to claim 2, wherein
the shielding structure and the second electrode are located at a same layer.

4. The display panel according to claim 2, wherein
the shielding structure comprises a first shielding layer and a second shielding layer; and
an orthographic projection, on the substrate, of an end that is of the first shielding layer and that is close to the display region partially overlaps the orthographic projection of the first electrode layer on the substrate, an orthographic projection, on the substrate, of an end that is of the first shielding layer and that is away from the display region overlaps an orthographic projection of the second shielding layer on the substrate, and the first shielding layer is connected to the second shielding layer through a via.

5. The display panel according to claim 4, wherein
the first shielding layer and the second electrode are located at a same layer; and
the second shielding layer is located at a metal layer that is at the array layer and that is closest to the display layer.

6. The display panel according to claim 1, wherein
the peripheral circuit comprises a plurality of transistors, and the transistor comprises a channel; and
the shielding structure is located on a side that is of the channel and that is close to the substrate.

7. The display panel according to claim 6, wherein
the display panel further comprises a light shielding layer located in the display region, and the shielding structure and the light shielding layer are located at a same layer.

8. The display panel according to claim 1, wherein
the display panel further comprises a voltage terminal located in the non-display region, and the shielding structure is electrically connected to the voltage terminal.

9. The display panel according to claim 8, wherein the voltage terminal is reused as a ground terminal or reused as a voltage terminal that provides a voltage to the first electrode layer.

10. An electronic device, comprising the display panel according to any one of claims 1 to 9.
